(19) Europäisches Patentamt European Patent Office Office européen des brevets

(11) **EP 4 550 047 A1**

(12) **EUROPEAN PATENT APPLICATION**

(43) Date of publication:
07.05.2025 Bulletin 2025/19

(21) Application number: 23207692.7

(22) Date of filing: 03.11.2023

(51) International Patent Classification (IPC):
*G03F 7/00* (2006.01)

(52) Cooperative Patent Classification (CPC):
G03F 7/70625; G03F 7/706837

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: ASML Netherlands B.V.
5500 AH Veldhoven (NL)

(72) Inventors:
• SCHOUMANS, Nicole
5500 AH Veldhoven (NL)
• VAENKATESAN, Vidya
5500 AH Veldhoven (NL)
• VAN LEEST, Adriaan, Johan
5500 AH Veldhoven (NL)

(74) Representative: ASML Netherlands B.V.
Corporate Intellectual Property
P.O. Box 324
5500 AH Veldhoven (NL)

(54) **SIDEWALL ANGLE METROLOGY**

(57) There is provided a method for determining angular information of one or more structures comprising: illuminating a first surface portion of said one or more structures with an illumination beam and measuring radiation scattered therefrom to determine a first signal; determining a first asymmetry metric value describing degree of asymmetry of the first signal; and determining the angular information based on at least the first asymmetry metric value, wherein the illumination beam comprises a spot size smaller in at least one dimension of a smallest element of the first surface portion.

Fig. 7

**EP 4 550 047 A1**

**Description**

FIELD

The present invention relates to methods and apparatus usable, for example, in the manufacture of devices by lithographic techniques, and to methods of manufacturing devices using lithographic techniques.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. including part of a die, one die, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. These target portions are commonly referred to as "fields".

In the manufacture of complex devices, typically many lithographic patterning steps are performed, thereby forming functional features in successive layers on the substrate. A critical aspect of performance of the lithographic apparatus is therefore the ability to place the applied pattern correctly and accurately in relation to features laid down (by the same apparatus or a different lithographic apparatus) in previous layers. For this purpose, the substrate is provided with one or more sets of alignment marks. Each mark is a structure whose position can be measured at a later time using a position sensor, typically an optical position sensor. The lithographic apparatus includes one or more alignment sensors by which positions of marks on a substrate can be measured accurately. Different types of marks and different types of alignment sensors are known from different manufacturers and different products of the same manufacturer.

In other applications, metrology sensors are used for measuring exposed structures on a substrate (either in resist and/or after etch). A fast and non-invasive form of specialized inspection tool is a scatterometer in which a beam of radiation is directed onto a target on the surface of the substrate and properties of the scattered or reflected beam are measured. Examples of known scatterometers include angle-resolved scatterometers of the type described in US2006033921A1 and US2010201963A1. In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark-field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20160258310A, US20160271740A and WO2013178422A1. These targets can be smaller than the illumination spot and may be surrounded by product structures on a wafer. Multiple gratings can be measured in one image, using a composite grating target. The contents of all these applications are also incorporated herein by reference.

When creating large structures using thick layers of resist, the resulting profile of the structures may relate to yield. A slope, or angle, of a sidewall of a profile of a structure may be known as a sidewall angle (SWA). It is desirable to perform accurate and non-destructive measurements of a sidewall angle.

SUMMARY

In a first aspect, there is provided a method for determining angular information of one or more structures comprising: illuminating a first surface portion of said one or more structures with an illumination beam and measuring radiation scattered therefrom to determine a first signal; determining a first asymmetry metric value describing degree of asymmetry of the first signal; and determining the angular information based on at least the first asymmetry metric value, wherein the illumination beam comprises a spot size smaller in at least one dimension of a smallest element of the first surface.

BRIEF DESCRIPTION OF THE DRAWINGS

Embodiments of the invention will now be described, by way of example only, with reference to the accompanying drawings, in which:

Figure 1 depicts a lithographic apparatus;
Figure 2 illustrates schematically measurement and exposure processes in the apparatus of Figure 1;

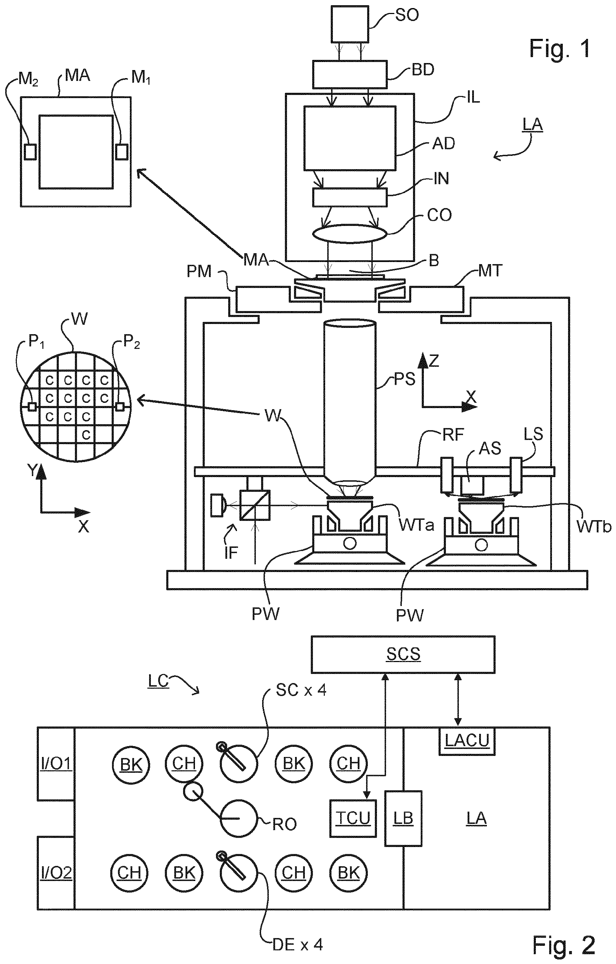

Figure 2 depicts a schematic overview of a lithographic cell;

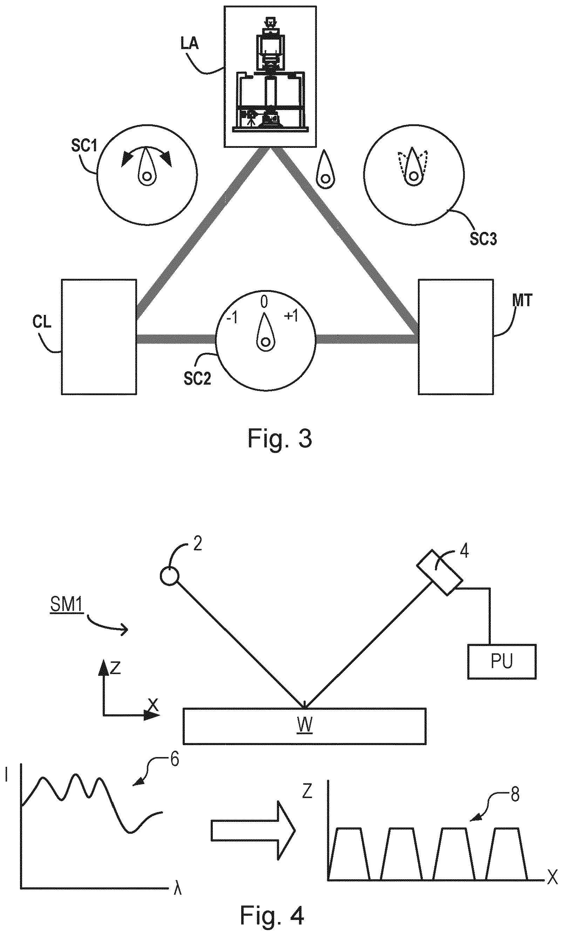

Figure 3 depicts a schematic representation of holistic lithography, representing a cooperation between three key technologies to optimize semiconductor manufacturing;
Figure 4 depicts a schematic overview of a scatterometry apparatus useable as a metrology device in methods disclosed herein;

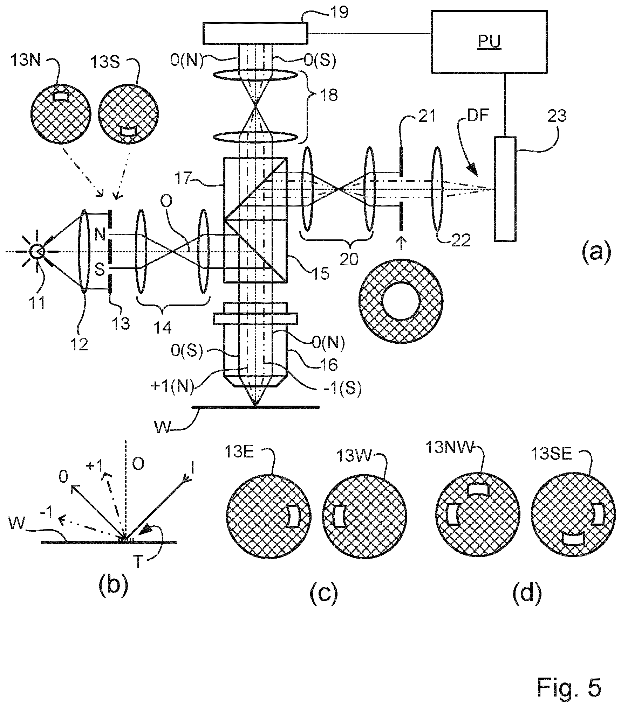

Figure 5(a) comprises a schematic diagram of a dark-field scatterometer for use in measuring targets according to embodiments of the invention using a first pair of illumination apertures;

Figure 5(b) illustrates a detail of diffraction spectrum of a target grating for a given direction of illumination;

Figure 5(c) illustrates a second pair of illumination apertures providing further illumination modes in using the scatterometer for diffraction based overlay measurements; and

Figure 5(d) illustrates a third pair of illumination apertures combining the first and second pair of apertures;

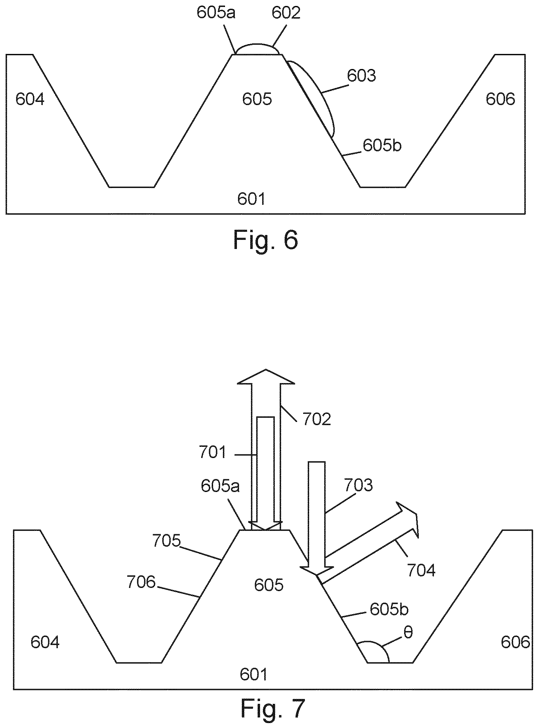

Figure 6 depicts a patterned resist comprising resist structures in accordance with some aspects of the present disclosure;

Figure 7 depicts a patterned resist comprising resist structures in accordance with some aspects of the present disclosure.

DETAILED DESCRIPTION

Before describing embodiments of the invention in detail, it is instructive to present an example environment in which embodiments of the present invention may be implemented.

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support MT holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so-called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

The lithographic apparatus may comprise an aberration sensor for the verification of an aberration fingerprint of the projection system PS. In an embodiment such an aberration fingerprint, i.e. aberrations per field point of the projection system PS, may be determined using a such wavefront aberration sensor. A wavefront aberration sensor of a known type, for instance such as described in US2002/0001088 may be used. Such a wavefront aberration sensor may be based on the principle of shearing interferometry and comprises a source module and a sensor module. The source module may comprise a patterned layer of chromium that is placed in the object plane (i.e. where during production the pattern of the patterning means is) of the projection system PS and has additional optics provided above the chromium layer. The combination provides a wavefront of radiation to the entire pupil of the projection system PS. The sensor module may comprise a patterned layer of chromium that is placed in the image plane of the projection system (i.e. where during production the substrate W is) and a camera that is placed some distance behind said layer of chromium. The patterned layer of chromium on the sensor module diffracts radiation into several diffraction orders that interfere with each other giving rise to an interferogram. The interferogram is measured by the camera. The aberrations in the projection lens can be determined by software based upon the measured interferogram. The wavefront aberration sensor may be configured to transfer information with respect to the aberration fingerprint towards the control unit.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment marks may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to as 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

A metrology apparatus suitable for use in embodiments of the invention is shown in Figure 5(a). A target T and diffracted rays of measurement radiation used to illuminate the target are illustrated in more detail in Figure 5(b). The metrology apparatus illustrated is of a type known as a dark-field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures, such as those which enable simultaneous illumination and detection from two opposing directions in combination with optical wedges to separate the resultant images. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or + 1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another example, on-axis illumination of the targets is used and an aperture stop with an off-axis aperture is used to pass substantially only one first order of diffracted light to the sensor. In yet other examples, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

In metrology, the profile of a structure may be an important metric relating to yield. This may be particularly the case when printing structures in thick resists. Thus, it is desirable to perform an accurate measurement of the profile of a structure. More specifically, it is desirable to accurately measure a sidewall angle (SWA) of a structure.

Historically, scanning electron microscope (SEM) systems have been used to measure SWAs. A top-down SEM configuration may be used to measure an average SWA by measuring the width of a transition as seen by the scattered electrons of the SEM. However, to resolve the average SWA using an SEM in this way, an accurate determination of the height of the resist is required. Thus, SEM results depend on a selected threshold and accuracy of the determined resist height information. Resist height information may be determined, for example, using atomic force microscopy (AFM). Such height measurements that require contact with a structure may damage the resist. Furthermore, SEM measurements may lead to shrinkage of a pattern resulting in local changes in structures on a wafer.

Other examples of SWA measurement include exclusive AFM measurements which may damage a sample and require a long and narrow tip, or cleaving, whereby a cross section of a resist profile on the sample may be accessed that can subsequently be measured. Owing to the destructive nature of cleaving, a sample can deform during the cleaving process leading to an inaccurate measurement, and it may be difficult to align the cleaving fault line perpendicular to the desired structure to be measured.

According to some aspects of the present disclosure, it may be possible to extract angular information (such as an absolute local SWA or a local change in SWA), of a structure using a metrology tool, e.g., such as a scatterometer based metrology tool. For example, the scatterometer based metrology tool may comprise or be similar to a tool such as illustrated in Figure 4 or Figure 5. In particular, such a method may use a pupil signal or angularly resolved signal of such a metrology tool (e.g., a detector or camera signal or image captured in a pupil plane or conjugate thereof (an angularly resolved plane), such as by detector 19 in Figure 5).

Such a method may comprise measuring a structure with an illumination beam comprising a spot size smaller in at least one dimension of the substrate plane of the smallest element, feature or sub-structure of the structure (e.g., a target) being measured. For example, the spot size may be smaller than the sub-structure in at least the substrate plane dimension perpendicular to the direction along which the wall extends, for which the SWA is being measured.

The method may comprise determining the SWA from a degree of symmetry of the pupil signal. In some cases, a symmetric pupil signal may correspond to a local flat area, and an asymmetric pupil may correspond to a local sloped area. In other words, the asymmetry of the pupil signal may be related to the derivative of the structure.

Advantageously, the methods presented herein are non-destructive and thus enable measurement of SWAs without damaging resist or otherwise adversely affecting structures on a wafer. Furthermore, the described methods may be faster to implement than known methods, thus improving system throughput.

The degree of asymmetry within a pupil may be quantified by an asymmetry metric. The asymmetry metric may be a scalar value describing a comparison (e.g., a ratio or difference) of a first signal magnitude value (e.g., intensity or amplitude) from a first portion of the pupil and a second signal magnitude value from a second portion of the pupil, the second portion of the pupil symmetrically corresponding to the first portion of the pupil. In this context, symmetrically corresponding may comprise being in mirror symmetrical locations of the pupil (e.g., an upper portion and lower portion in mirror symmetrical positions either side of a central axis. The first and second signal magnitude values may each comprise a respective single pixel value, or more practically comprise an average (e.g., mean) over multiple pixel values. In a specific example the first portion of the pupil may comprise a first half of the pupil (e.g., an upper half) and the second portion of the pupil may comprise a second half of the pupil (e.g., a lower half). Any averaging may comprise a weighted average (e.g., depending on an estimated reliability of the pixel values)

The method may comprise a calibration step in order to calibrate the relationship between the asymmetry metric and the SWA. This is necessary if an absolute SWA value is to be determined using this method. Alternatively, a relative SWA value (e.g., a change in SWA) may be determined without the need for a calibration step.

The calibration step may assume a linear relationship between asymmetry metric and SWA. In such an embodiment, a reference SWA measurement may be obtained (e.g., assumed, measured and/or simulated) and a corresponding asymmetry metric value measured for the same structure (e.g., line). From this the relationship or slope (proportionality constant) can be determined as the ratio of the reference SWA measurement and the asymmetry metric value. This ratio can be multiplied with any subsequently measured asymmetry metric value (e.g., as calibrated per lot or multiple substrates, per substrate or per portion thereof (e.g., per field)).

Referring to Figure 6, patterned resist 601 may comprise resist structures 604, 605, 606 having a physical profile. For particularly thick resist structures, the physical profile may be an important metric relating to yield, i.e., a number of functioning devices on a finished wafer.

A metrology tool, for example a scatterometer, may focus a radiation beam, or a laser spot, on a surface of a resist structure 604, 605, 606 and capture light scattered from the surface to determine information about the geometric properties of the reflecting surface. Figure 6 shows a first laser spot 602 positioned on a flat surface 605a of a resist structure 605 and a second laser spot 603 positioned on a surface portion, or sidewall 605b of resist structure 605. Notably, laser spot 603 may have a smaller diameter than the width of flat surface 605a, which may correspond to a smallest structure width on the resist structure 605.

Referring to Figure 7, when a first radiation beam 701 from a scatterometer reaches flat surface 605a of structure 605, scattered radiation, e.g., first scattered radiation 702, is reflected back towards a detector of the scatterometer. The first scattered radiation 702 may propagate in the same path as the first radiation beam 701. That is, the angle of reflection of the first scattered radiation 702 may be zero degrees. In this case, the pupil may comprise a symmetric pupil signal, which may be known as a symmetric pupil. A symmetric pupil may indicate that a reflection surface (e.g., flat surface 605a) is flat.

Still referring to Figure 7, a second radiation beam 703 from a scatterometer may reach sidewall 605b of structure 605, which may scatter radiation, e.g., second scattered radiation 704, in a direction different from the direction of the second radiation beam 703. That is, the angle of reflection of the second scattered radiation 704 is non-zero. In this case, the pupil may comprise an asymmetric pupil signal, which may be known as an asymmetric pupil. An asymmetric pupil may indicate that the reflection surface (e.g., sidewall 605b) is sloped.

Accordingly, a symmetric pupil may correspond to a locally flat area on patterned resist 601 and an asymmetric pupil may correspond to a locally sloped area on patterned resist 601. In an aspect, the asymmetry of the pupil may be related to the derivative of a structure (e.g., structure 605). For example, the local angle of a slope comprising part of a structure (e.g., a sidewall) may be associated with a degree of asymmetry of a pupil signal. Advantageously, in this way the sidewall angle $\theta$ of the structure may be derived from the pupil signal. This may provide a contact free and non-destructive method for resolving a sidewall angle $\theta$ of a structure (e.g., resist structures 604, 605, 606), without requiring accurate height information relating to the resist.

The following describes a non-limiting example of a method of determining angular information of a structure in accordance with aspects of the present disclosure.

A first surface portion 705 of a structure (e.g., one or more of resist structures 604, 605, 606) may be illuminated by an illumination beam (e.g., an illumination beam from a metrology tool, for example a scatterometer Fig. 4). Light scattered from the first surface portion 705 may be measured (e.g., by detector 4 (Fig. 4)) and a first pupil signal may be determined from the measurement.

The first pupil signal may have an associated degree of asymmetry. In some examples, a first asymmetry metric value $\alpha_0$ corresponding to the degree of asymmetry of the first pupil signal may be determined based on a mean value of an upper part of the first pupil and a mean value of a lower part of the first pupil signal. That is, the mean value of the upper part of the first pupil signal may be subtracted from the lower part of the first pupil signal to provide the first asymmetry metric value $\alpha_0$. In some examples, the first asymmetry metric value $\alpha_0$ may be determined from a weighted average of the upper part of the first pupil signal and a weighted average of the lower part of the pupil signal.

A second surface portion 706 may be illuminated by the illumination beam. The second surface portion 706 may correspond to the same structure as the first surface portion 705 or a different structure. Light scattered from the second surface portion 706 may be measured and a second pupil signal may be determined from the measurement.

The second pupil signal may also have an associated degree of asymmetry. In some examples, a second asymmetry metric value $\alpha_1$ corresponding to the degree of asymmetry of the second pupil signal may be calculated based on a mean value of an upper part of the second pupil signal and a mean value of a lower part of the second pupil signal. That is, the mean value of the upper portion or half of the second pupil signal may be subtracted from the lower portion or half of the second pupil signal to provide the second asymmetry metric value $\alpha_1$. In some examples, the second asymmetry metric value $\alpha_1$ may be determined from a weighted average of the upper part of the second pupil signal and a weighted average of the lower part of the second pupil signal.

A reference angle $\theta^{\circ}_{ref}$ of a sidewall angle of the first surface portion 705 may be determined. The reference angle $\theta^{\circ}_{ref}$ may in some cases be determined based on at least one of an assumed value (e.g., for best focus/dose) based on experience, as determined in one or more simulations, or as measured from an external referencing tool such as atomic force microscopy (AFM), transmission electron microscopy (TEM), scanning electron microscopy (SEM), optical critical dimension (OCD) spectroscopy or X-ray spectroscopy (XRS). The reference angle $\theta^{\circ}_{ref}$ of the first structure may correspond to the degree of asymmetry $\alpha_0$ of the first pupil signal.

Accordingly, an angle $\theta^{\circ}_{SWA}$ corresponding to a SWA of the second surface portion 706 may be determined according to the following relationship between $\alpha_0$, $\alpha_1$, and $\theta^{\circ}_{ref}$:

$$\frac{\alpha_1}{\alpha_0} * \theta_{ref} = \theta_{SWA}$$

i.e., the slope or constant of proportionality may be determined as $\dfrac{\theta_{ref}}{\alpha_0}$ and multiplied by $\alpha_1$ (and other subsequently measured asymmetry metrics) to determine $\theta_{SWA}$.

Advantageously, an unknown SWA (i.e., $\theta_{SWA}$) may be determined from the degree of the symmetry of the first pupil signal (first asymmetry metric), the degree of the symmetry of the second pupil signal and reference angle (second asymmetry metric). This may avoid using alternative destructive methods and may not require accurate height information of a resist structure to determine the SWA.

The above example may hold true for a linear relationship between pupil asymmetry and SWA. In some cases, the relationship between pupil asymmetry and SWA may be non-linear. In such cases, further refence data (e.g., simulations or external reference tool data) may be required to determine the non-linear relationship.

In some cases, an absolute SWA measurement may not be required (e.g., when it may only be of interest how a SWA changes through focus). In this case, a reference angle may not be required. For example, the degree of asymmetry of the first pupil signal may correspond to a local SWA of the first surface portion 705 and the degree of symmetry of the second pupil signal may correspond to a local SWA of the second surface portion 706. Thus, a relative SWA value or ratio of $\alpha_2/\alpha_1$ may be determined that may indicate a change between the local SWA of the first surface portion 705 and the local SWA of the second surface portion 706. For example, a ratio of 1 may indicate that the SWA does not change, a ratio > 1 may indicate an increase in SWA between a location of the first pupil signal measurement and a location of the second pupil signal measurement and a ratio of < 1 may indicate a decrease in SWA between a location of the first pupil signal measurement and a location of the second pupil signal measurement.

The above examples and embodiments are described with respect to angularly resolved or pupil measurements, e.g., wherein a metrology apparatus may operate in a bright-field, or pupil, mode to provide said measurements. It will be appreciated that the measurement signal may be an imaged signal captured at an image plane; for example where said metrology apparatus may operate in a dark-field mode, and the imaged signal comprises for example a dark-field image. In this case, a degree of asymmetry may be determined from an intensity of diffracted radiation as represented in the (e.g., dark-field) image. Thus, it will be appreciated that the above-mentioned methods for determining SWA may be applied to imaged signals or dark-field measurements of a structure.

In some embodiments, a metrology apparatus may be operable to perform measurements at a plurality of different wavelengths. Advantageously, by performing measurements at a plurality of different wavelengths, a signal to noise (SNR) ratio may be increased, thus improving signal quality. In this case, a plurality of signals captured for a plurality of wavelengths may have a plurality of different asymmetries. The plurality of respective signals may be combined, e.g., linearly combined, to provide a combined signal from which a degree of asymmetry may be determined.

In some aspects, there may be provided a metrology apparatus for determining angular information of one or more structures, the metrology apparatus operable to: illuminate a first surface portion of said one or more structures with an illumination beam and measure radiation scattered therefrom to determine a first signal; determine a first asymmetry metric value describing degree of asymmetry of the first signal; and determine the angular information based on at least the first asymmetry metric value, wherein the illumination beam comprises a spot size smaller in at least one dimension of a smallest element of the first surface portion.

The metrology apparatus may be further operable to: illuminate at least a second surface portion of said one or more structures with the illumination beam and measure radiation scattered therefrom to determine at least one second signal; determine at least one second asymmetry metric value describing a degree of asymmetry of a respective second signal in said at least one second signal; and determine the angular information based on at least the first asymmetry metric value and the at least one second asymmetry metric value.

The metrology apparatus may be operable to obtain reference angular information of the first surface portion; and use the reference angular information to calibrate said determining the angular information.

The metrology apparatus may be operable to to determine a proportionality constant from the reference angular information and the first asymmetry metric value; and use the proportionality constant to translate each said at least one second asymmetry metric value to said angular information. The reference angular information may comprise one or more of: assumed reference angular information, simulated reference angular information and/or measured reference angular information. The reference angular information may comprise measured reference angular information as measured via one or more of: atomic force microscopy, transmission electron microscopy, scanning electron microscopy, optical critical dimension spectroscopy or X-ray spectroscopy.

The angular information may comprise at least one local sidewall angle.

The metrology apparatus may be operable to determine the angular information further comprises being operable to determining a ratio of the first asymmetry metric value and each said at least one second asymmetry metric value, wherein the ratio may indicate a local change in a sidewall angle of the first surface portion and the second surface portion, wherein a ratio of 1 indicates no change in the sidewall angle, a ratio > 1 indicates an increase in the sidewall angle, and a ratio < 1 indicates a decrease in the sidewall angle.

The metrology apparatus may be operable to determine each said asymmetry metric value by being operable to determine a comparison of a first signal magnitude value from a first portion of the corresponding signal and a second signal magnitude value from a second portion of the corresponding signal, the second portion of the signal symmetrically corresponding to the first portion of the signal. Said first signal magnitude value and said second signal magnitude value each may comprise an averaged value over said first portion and second portion respectively. Each said averaged value may comprise a weighted averaged value.

The illumination spot may be less than or equal to 3μm, or the illumination spot may be less than or equal to 2μm.

The metrology apparatus may be operable to capture said first and/or second signal as an angularly resolved signal captured at a pupil plane of the metrology apparatus.

The metrology apparatus may be operable to capture said first and/or second signal as a bright-field signal.

The metrology apparatus may be operable to capture said first and/or second signal as an imaged signal captured at an image plane of the metrology apparatus.

The metrology apparatus may be operable to capture said first and/or second signal as a dark-field imaged signal.

Said illumination beam may comprise a plurality of wavelengths; the apparatus being further operable to linearly combine respective signals in the scattered radiation for each of said plurality of wavelengths to provide the first and/or second signal.

While specific embodiments of the invention have been described above, it will be appreciated that the invention may be practiced otherwise than as described.

Further embodiments are disclosed in the subsequent list of numbered clauses:

> 1. A method of determining angular information of one or more structures comprising:
>
> > illuminating a first surface portion of said one or more structures with an illumination beam and measuring radiation scattered therefrom to determine a first signal;
> > determining a first asymmetry metric value describing degree of asymmetry of the first signal; and
> > determining the angular information based on at least the first asymmetry metric value, wherein the illumination beam comprises a spot size smaller in at least one dimension of a smallest element of the first surface portion.
>
> 2. The method as defined in clause 1 further comprising:
>
> > illuminating at least a second surface portion of said one or more structures with the illumination beam and measuring radiation scattered therefrom to determine at least one second signal;
> > determining at least one second asymmetry metric value describing a degree of asymmetry of a respective second signal in said at least one second signal; and
> > determining the angular information based on at least the first asymmetry metric value and the at least one second asymmetry metric value.
>
> 3. The method as defined in any of clauses 1 or 2 further comprising obtaining reference angular information of the first surface portion; and

using the reference angular information to calibrate said determining the angular information.

4. The method as defined in clause 3, comprising determining a proportionality constant from the reference angular information and the first asymmetry metric value; and

using the proportionality constant to translate each said at least one second asymmetry metric value to said angular information.

5. The method as defined in clause 4, wherein the reference angular information comprises one or more of: assumed reference angular information, simulated reference angular information and/or measured reference angular information.

6. The method as defined in clause 5, wherein the reference angular information comprises measured reference angular information as measured via one or more of: atomic force microscopy, transmission electron microscopy, scanning electron microscopy, optical critical dimension metrology, ellipsometry, or X-ray spectroscopy.

7. The method as defined in any previous clause, wherein said angular information comprises at least one local sidewall angle.

8. The method as defined in clause 2, wherein the step of determining angular information comprises determining a ratio of the first asymmetry metric value and each said at least one second asymmetry metric value, wherein the ratio indicates a local change in a sidewall angle of the first surface portion and the second surface portion.

9. The method as defined in clause 8, wherein a ratio of 1 indicates no change in the sidewall angle, a ratio > 1 indicates an increase in the sidewall angle, and a ratio < 1 indicates a decrease in the sidewall angle.

10. The method as defined in any previous clause, wherein determining each said asymmetry metric value comprises determining a comparison of a first signal magnitude value from a first portion of the corresponding signal and a second signal magnitude value from a second portion of the corresponding signal, the second portion of the signal symmetrically corresponding to the first portion of the signal.

11. The method as defined in clause 10, wherein said first signal magnitude value and said second signal magnitude value each comprise an averaged value over said first portion and second portion respectively.

12. The method as defined in clause 11, wherein each said averaged value comprises a weight-averaged value.

13. The method as defined in any previous clause, wherein the illumination spot is less than or equal to 3 $\mu$m.

14. The method as defined in any previous clause, wherein the illumination spot is less than or equal to 2 $\mu$m.

15. The method as defined in any previous clause, wherein said first and/or second signal is an angularly resolved signal captured at a pupil plane.

16. The method as defined in any of clauses 1 to 14, wherein said first and/or second signal is an imaged signal captured at an image plane.

17. The method as defined in any previous clause, wherein said illumination beam comprises a plurality of wavelengths, said method further comprising: linearly combining respective signals for each of said plurality of wavelengths to provide the first and/or second signal.

18. A metrology apparatus for determining angular information of one or more structures, the metrology apparatus operable to:

illuminate a first surface portion of said one or more structures with an illumination beam and measure radiation scattered therefrom to determine a first signal;

determine a first asymmetry metric value describing degree of asymmetry of the first signal; and

determine the angular information based on at least the first asymmetry metric value, wherein the illumination beam comprises a spot size smaller in at least one dimension of a smallest element of the first surface portion.

19. The metrology apparatus as defined in clause 18, further operable to:

illuminate at least a second surface portion of said one or more structures with the illumination beam and measure radiation scattered therefrom to determine at least one second signal;

determine at least one second asymmetry metric value describing a degree of asymmetry of a respective second signal in said at least one second signal; and

determine the angular information based on at least the first asymmetry metric value and the at least one second asymmetry metric value.

20. The metrology apparatus as defined in any of clauses 18 and 19, further operable to obtain reference angular information of the first surface portion; and

use the reference angular information to calibrate said determining the angular information.

21. The metrology apparatus as defined in clause 20, further operable to determine a proportionality constant from the reference angular information and the first asymmetry metric value; and

use the proportionality constant to translate each said at least one second asymmetry metric value to said angular information.

22. The metrology apparatus as defined in clause 21, wherein the reference angular information comprises one or more of: assumed reference angular information, simulated reference angular information and/or measured reference angular information.

23. The metrology apparatus as defined in clause 22, wherein the reference angular information comprises measured reference angular information as measured via one or more of: atomic force microscopy, transmission electron microscopy, scanning electron microscopy, optical critical dimension metrology, ellipsometry or X-ray spectroscopy.

24. The metrology apparatus as defined in any of clauses 18 to 23, wherein said angular information comprises at least one local sidewall angle.

25. The metrology apparatus of clause 19, wherein the step of being operable to determine the angular information further comprises being operable to determining a ratio of the first asymmetry metric value and each said at least one second asymmetry metric value, wherein the ratio indicates a local change in a sidewall angle of the first surface portion and the second surface portion.

26. The metrology apparatus of clause 25, wherein a ratio of 1 indicates no change in the sidewall angle, a ratio > 1 indicates an increase in the sidewall angle, and a ratio < 1 indicates a decrease in the sidewall angle.

27. The metrology apparatus of any of clauses 18 to 26, wherein the step of being operable to determine each said asymmetry metric value comprises being operable to determine a comparison of a first signal magnitude value from a first portion of the corresponding signal and a second signal magnitude value from a second portion of the corresponding signal, the second portion of the signal symmetrically corresponding to the first portion of the signal.

28. The metrology apparatus as defined in clause 27, wherein said first signal magnitude value and said second signal magnitude value each comprise an averaged value over said first portion and second portion respectively.

29. The metrology apparatus as defined in clause 28, wherein each said averaged value comprises a weight-averaged value.

30. The metrology apparatus as defined in any of clauses 18 to 29, wherein the illumination spot is less than or equal to $3\mu$m.

31. The metrology apparatus as defined in any of clauses 18 to 29, wherein the illumination spot is less than or equal to $2\mu$m.

32. The metrology apparatus as defined in any of clauses 18 to 31, being operable to capture said first and/or second signal as an angularly resolved signal captured at a pupil plane of the metrology apparatus.

33. The metrology apparatus as defined in clause 32, being operable to capture said first and/or second signal as a bright-field signal.

34. The metrology apparatus as defined in any of clauses 18 to 31, being operable to capture said first and/or second signal as an imaged signal captured at an image plane of the metrology apparatus.

35. The metrology apparatus as defined in clause 34, being operable to capture said first and/or second signal as a dark-field imaged signal

36. The metrology apparatus as clamed in any of clauses 18 to 35, wherein said illumination beam comprises a plurality of wavelengths; the apparatus being further operable to:

linearly combine respective signals in the scattered radiation for each of said plurality of wavelengths to provide the first and/or second signal.

37. The metrology apparatus of clauses 18 to 36 comprising a scatterometer apparatus.

38. A lithography cell comprising a lithography apparatus and the metrology apparatus according to any of clauses 18 to 37.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 1-100 nm), as well as particle beams, such as ion beams or electron beams.

The term "lens", where the context allows, may refer to any one or combination of various types of optical components, including refractive, reflective, magnetic, electromagnetic and electrostatic optical components. Reflective components are likely to be used in an apparatus operating in the UV and/or EUV ranges.

The breadth and scope of the present invention should not be limited by any of the above-described exemplary embodiments, but should be defined only in accordance with the following claims and their equivalents.

**Claims**

1.  A method of determining angular information of one or more structures comprising:

    illuminating a first surface portion of said one or more structures with an illumination beam and

measuring radiation scattered therefrom to determine a first signal;

determining a first asymmetry metric value describing degree of asymmetry of the first signal; and

determining the angular information based on at least the first asymmetry metric value, wherein the illumination beam comprises a spot size smaller in at least one dimension of a smallest element of the first surface portion.

2. The method as claimed in claim 1 further comprising:

illuminating at least a second surface portion of said one or more structures with the illumination beam and measuring radiation scattered therefrom to determine at least one second signal;

determining at least one second asymmetry metric value describing a degree of asymmetry of a respective second signal in said at least one second signal; and

determining the angular information based on at least the first asymmetry metric value and the at least one second asymmetry metric value.

3. The method as claimed in any of claims 1 or 2 further comprising obtaining reference angular information of the first surface portion; and

using the reference angular information to calibrate said determining the angular information.

4. The method as claimed in claim 3, comprising determining a proportionality constant from the reference angular information and the first asymmetry metric value; and

using the proportionality constant to translate each said at least one second asymmetry metric value to said angular information.

5. The method as claimed in claim 4, wherein the reference angular information comprises one or more of: assumed reference angular information, simulated reference angular information and/or measured reference angular information.

6. The method as claimed in claim 5, wherein the reference angular information comprises measured reference angular information as measured via one or more of: atomic force microscopy, transmission electron microscopy, scanning electron microscopy, optical critical dimension metrology, ellipsometry, or X-ray spectroscopy.

7. The method as claimed in any previous claim, wherein said angular information comprises at least one local sidewall angle.

8. The method as claimed in claim 2, wherein the step of determining angular information comprises determining a ratio of the first asymmetry metric value and each said at least one second asymmetry metric value, wherein the ratio indicates a local change in a sidewall angle of the first surface portion and the second surface portion.

9. The method as claimed in any previous claim, wherein determining each said asymmetry metric value comprises determining a comparison of a first signal magnitude value from a first portion of the corresponding signal and a second signal magnitude value from a second portion of the corresponding signal, the second portion of the signal symmetrically corresponding to the first portion of the signal.

10. The method as claimed in claim 9, wherein said first signal magnitude value and said second signal magnitude value each comprise an averaged value over said first portion and second portion respectively.

11. The method as claimed in any previous claim, wherein the illumination spot is less than or equal to $3\mu m$.

12. A metrology apparatus for determining angular information of one or more structures, the metrology apparatus operable to:

illuminate a first surface portion of said one or more structures with an illumination beam and measure radiation scattered therefrom to determine a first signal;

determine a first asymmetry metric value describing degree of asymmetry of the first signal; and

determine the angular information based on at least the first asymmetry metric value, wherein the illumination beam comprises a spot size smaller in at least one dimension of a smallest element of the first surface portion.

13. The metrology apparatus as claimed in claim 12, further operable to:

illuminate at least a second surface portion of said one or more structures with the illumination beam and measure radiation scattered therefrom to determine at least one second signal;

determine at least one second asymmetry metric value describing a degree of asymmetry of a respective second signal in said at least one second signal; and

determine the angular information based on at least the first asymmetry metric value and the at least one second asymmetry metric value.

14. The metrology apparatus as claimed in claim 12 or 13, being operable to capture said first and/or second signal as an angularly resolved signal captured at a pupil plane of the metrology apparatus.

15. The metrology apparatus as claimed in claim 12 or 13, being operable to capture said first and/or second signal as an imaged signal captured at an image plane of the metrology apparatus.

Fig. 1

Fig. 2

Fig. 3

Fig. 4

Fig. 5

605a  602

604    605    603

605b

606

601

Fig. 6

702

701    703

605a

705    704

706

605

604    605b    θ    606

601

Fig. 7

Europäisches
Patentamt

European
Patent Office

Office européen
des brevets

# EUROPEAN SEARCH REPORT

**Application Number**

EP 23 20 7692

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | XIUJIE DOU ET AL: "Determination of steep sidewall angle using polarization-sensitive asymmetric scattering", MEASUREMENT SCIENCE AND TECHNOLOGY, IOP, BRISTOL, GB, vol. 32, no. 8, 17 May 2021 (2021-05-17), page 85201, XP020368357, ISSN: 0957-0233, DOI: 10.1088/1361-6501/ABFBAC [retrieved on 2021-05-17] * the whole document * | 1-15 | INV. G03F7/00 |
| A | LUCA CISOTTO ET AL: "Analytical calculation on the determination of steep side wall angles from far field measurements", JOURNAL OF OPTICS, INSTITUTE OF PHYSICS PUBLISHING, BRISTOL GB, vol. 20, no. 6, 25 April 2018 (2018-04-25), page 65601, XP020327526, ISSN: 2040-8986, DOI: 10.1088/2040-8986/AABB59 [retrieved on 2018-04-25] * the whole document * | 1-15 | |
| A | WO 2015/022239 A1 (ASML NETHERLANDS BV [NL]) 19 February 2015 (2015-02-19) * paragraph [0082]; figures 5-8 * | 1-15 | |
| A | US 2013/308142 A1 (STRAAIJER ALEXANDER [NL]) 21 November 2013 (2013-11-21) * paragraphs [0087] - [0098]; figures 7a, 7b, 8 * | 1-15 | |

TECHNICAL FIELDS
SEARCHED (IPC)

G03F

The present search report has been drawn up for all claims

| Place of search | Date of completion of the search | Examiner |
|---|---|---|
| Munich | 26 April 2024 | Weckesser, Jens |

EPO FORM 1503 03.82 (P04C01)

## ANNEX TO THE EUROPEAN SEARCH REPORT
## ON EUROPEAN PATENT APPLICATION NO.

EP 23 20 7692

This annex lists the patent family members relating to the patent documents cited in the above-mentioned European search report.
The members are as contained in the European Patent Office EDP file on
The European Patent Office is in no way liable for these particulars which are merely given for the purpose of information.

26-04-2024

| Patent document cited in search report | | Publication date | Patent family member(s) | | Publication date |
|---|---|---|---|---|---|
| WO 2015022239 | A1 | 19-02-2015 | CN | 105452963 A | 30-03-2016 |
| | | | KR | 20160043023 A | 20-04-2016 |
| | | | TW | 201514469 A | 16-04-2015 |
| | | | US | 2016154319 A1 | 02-06-2016 |
| | | | WO | 2015022239 A1 | 19-02-2015 |
| US 2013308142 | A1 | 21-11-2013 | NL | 2010717 A | 25-11-2013 |
| | | | US | 2013308142 A1 | 21-11-2013 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 2006066855 A1
- WO 2009078708 A
- WO 2009106279 A
- US 20110027704 A
- US 20110043791 A
- US 2011102753 A1
- US 20120044470 A
- US 20120123581 A
- US 20160258310 A
- US 20160271740 A
- WO 2013178422 A1
- US 20020001088 A
- US 20100328655 A
- US 20110249244 A

- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1